Europäisches Patentamt

European Patent Office

Office européen des brevets

(19)

(11) Publication number: 0 308 902 A2

# EUROPEAN PATENT APPLICATION

(21) Application number: 88115501.4

(51) Int. Cl.4: G03F 7/10

(22) Date of filing: 21.09.88

(30) Priority: 24.09.87 JP 237132/87

(43) Date of publication of application:
29.03.89 Bulletin 89/13

(84) Designated Contracting States:
DE FR

(71) Applicant: HITACHI, LTD.
6, Kanda Surugadai 4-chome Chiyoda-ku
Tokyo(JP)

(72) Inventor: Mochiji, Kozo
Sankopo Hachioji 301 17-3, Oiwakecho
Hachioji-shi(JP)
Inventor: Tomioka, Yasushi Hitachi Daiyon
Kyoshin Ryo
14-6, Nishikoigakubo-4-chome
Kokubunji-shi(JP)
Inventor: Kimura, Takeshi
11-18, Meguritacho-2-chome
Higashimurayama-shi(JP)

(74) Representative: Strehl, Schübel-Hopf,
Groening, Schulz
Maximilianstrasse 54 Postfach 22 14 55
D-8000 München 22(DE)

(54) Method for forming pattern by using langmuir-blodgett film.

(57) A method of forming a pattern is disclosed which comprises the steps of: forming a metal-containing Langmuir-Blodgett film (4, 4') on a substrate (1) through a thin film (3, 2') to be subjected to patterning; exposing the Langmuir-Blodgett film to an energy beam (6, 6') so that the Langmuir-Blodgett film is selectively irradiated with the energy beam; dissolving the unirradiated part of the Langmuir-Blodgett film to form a pattern of the Langmuir-Blodgett film; and selectively etching the thin film (3, 2') with reactive ions (7, 7') by using the pattern of the Langmuir-Blodgett film as a mask.

FIG. 1B

FIG. 1C

FIG. 1D

FIG. 1A

FIG. 1E

# METHOD FOR FORMING PATTERN BY USING LANGMUIR-BLODGETT FILM

## BACKGROUND OF THE INVENTION

The present invention relates to the lithography used in, for example, the fabrication process of a semiconductor integrated circuit, and more particularly to lithography which uses a resist film sensitive to radiations and can form an ultra-fine pattern very accurately.

As described in an article entitled "Polymerization in Langmuir-Blodgett Films and Resist Application" by A. Barraud (Thin Solid Films, 99, 1983, pages 317 -321), a Langmuir-Blodgett film (hereinafter referred to as "LB film") used as a resist film is made of only an organic compound, and moreover has a single layer structure. Hence, a conventional LB film used as a resist film is deficient in resistance to dry-etching used for fabricating a semiconductor device, and it is impossible to use the LB film as an actual resist film in making semiconductor elements.

## SUMMARY OF THE INVENTION

It is accordingly an object of the present invention to provide a method for forming a pattern by using an LF film which is resistant to dry-etching.

In order to attain the above object, according to the present invention, an LB film used as a resist film contains a metal, to obtain a dry-etching resisting LB film.

A metal containing LB film is a very thin film which is resistant to dry-etching and is excellent in orientation characteristics, and hence an ultra-fine pattern can be readily formed by the lithography using the metal containing LB film. Further, the metal contained in the LB film is oxidized when oxygen ion etching is carried out. Thus, the metal containing LB film can act as an excellent etching mask, and makes possible the accurate patterning for a semiconductor device material.

## BRIEF DESCRIPTION OF THE DRAWINGS

Figs. 1A to 1E are sectional views for explaining steps of an embodiment of a pattern forming method according to the present invention.

Fig. 2 is graph showing a thickness loss curve of an LB film which is made of aluminum stearate and is subjected to oxygen ion etching, and a thickness loss curve of an LB film which is made of stearic acid and is subjected to oxygen ion etching.

Figs. 3A to 3D are sectional views for explaining steps of another embodiment of a pattern forming method according to the present invention.

Fig. 4 is a graph showing a thickness loss curve of an LB film which is made of calcium $\omega$-tricosenoate and is subjected to fluorine ion etching, and a thickness loss curve of an LB film which is made of $\omega$-tricosenoic acid and is subjected to fluorine ion etching.

## DESCRIPTION OF THE PREFERRED EMBODIMENTS

### EMBODIMENT I

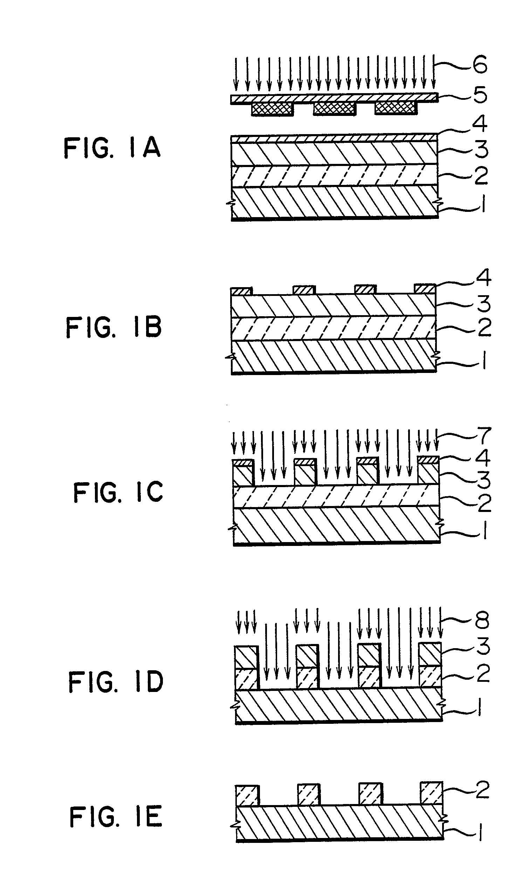

A first embodiment of a pattern forming method according to the present invention will be explained below, with reference to Figs. 1A to 1E. An aluminum film 2 which will be used for connection between semiconductor elements, is first deposited on a silicon substrate 1 to a thickness of 0.8 $\mu$m. Then, the aluminum film 2 is coated with a photoresist microposit (that is, lower resist film) 3 having a thickness of 2 $\mu$m. The lower resist film 3 is baked at 220°C for 30 minutes. Then, 30 layers of aluminum stearate are piled to form an LB film 4 on the lower resist film 3. It is needless to say that the stearic acid is one of alkyl carboxylic acids. Next, as shown in Fig. 1A, the LB film 4 is irradiated with soft X-rays 6 (for example, characteristic X-rays emitted from a molybdenum cathode and having a wavelength of 0.54 nm) at a dose rate of 20 mJ/cm² through an X-ray mask 5. The structure thus obtained is dipped in benzene used as a developer, to dissolve the unirradiated part of the LB film 4 as shown in Fig. 1B. Then, the structure is exposed to an atmosphere of oxygen ions 7, to subject the lower resist film 3 to reactive ion etching as shown in Fig. 1C. The reactive ion etching is carried out for 60 minutes under conditions that the pressure of oxygen is made equal to 1 Torr and a radio-frequency power of 100 W is supplied to the oxygen ions 7. Next, as shown in Fig. 1D, the structure is exposed to an atmosphere of chlorine ions 8, to subject the aluminum film 2 to reactive ion etching which using the lower resist film 3 as a mask. The reactive ion etching is carried out for 20 minutes under conditions that the pressure of BCl₃ using as a reaction gas is made equal to 0.2 Torr, and a radio-frequency power of 100W is supplied to the BCl₃ gas. Finally, the lower resist film 3 is incinerated by an oxygen plasma, and thus a desired wiring pattern formed of the aluminum film 2 is left as shown in Fig. 1E.

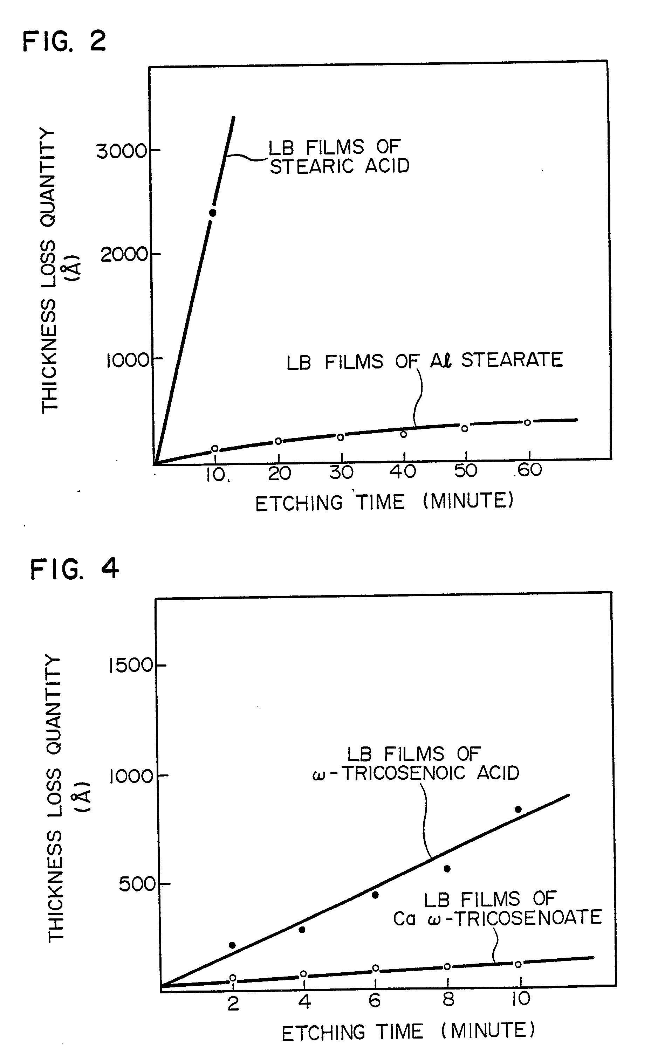

According to the present embodiment, the lower resist film 3 can be selectively etched by using the ultra-thin film 4 which is resistant to oxygen ion etching, as a mask, and hence a fine pattern can be formed very accurately. Fig. 2 shows the thickness loss curve of an LB film which is made of aluminum stearate and is subjected to oxygen ion etching, and the thickness loss curve of another LB film which is made of stearic acid and is subjected to oxygen ion etching. As is apparent from Fig. 2, the aluminum containing LB film is excellent in resistance to dry etching.

EMBODIMENTS II

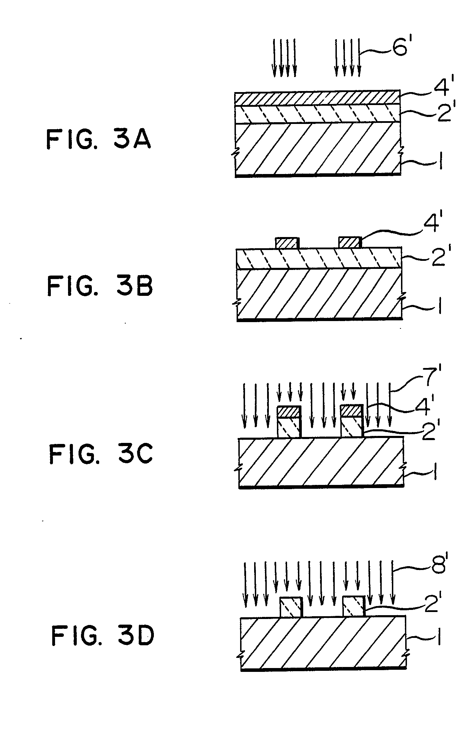

Now, a second embodiment of a pattern forming method according to the present invention will be explained below, with reference to Figs. 3A to 3D. After semi-conductor elements have been formed in a surface of a silicon substrate 1, a silicon oxide film 2′ doped with phosphorus and serving as an insulating film is deposited on the surface of the silicon substrate 1 by the CVD method (namely, chemical vapor deposition method) to a thickness of 0.6 μm. Further, an LB film 4′ made of the calcium salt of ω-tricosenoic acid $CH_2 = CH(CH_2)_{20}COOH$ is formed on the silicon oxide film 2′ to a thickness of 0.2 μm. It is needless to say that the ω-tricosenoic acid is one of organic acids having a double bond. Then, as shown in Fig. 3A, the LB film 4′ is selectively exposed to an electron beam (that is, an energy beam) 6′ so that the electron beam 6′ forms a desired pattern on the LB film 4′. In more detail, the LB film 4′ is selectively irradiated with the electron beam 6′ having a kinetic energy of 30 KeV at an exposure dosage of $5 \times 10^{-7}$ C/cm². Then, toluene is used as a developer, to dissolve the unexposed part of the LB film 4′ as shown in Fig. 3B. Then, as shown in Fig. 3°C, the silicon oxide film 2′ is subjected to reactive ion etching while using the pattern of the LB film 4′ as a mask. The reactive ion etching is carried out in a state that the pressure of $CF_4$ used as an etching gas 7′ is made equal to 0.05 Torr. Finally, the LB film 4′ is incinerated by an oxygen plasma 8′, and thus a desired pattern formed of the silicon oxide film 2′ is left as shown in Fig. 3D.

According to the present embodiment, a material for forming a semiconductor device can be dry etched only by using the LB film 4′. Hence, the lithographic process can be simplified, and moreover the accuracy in forming a fine pattern is improved. Fig. 4 shows the thickness loss curve of an LB film which is made of calcium ω-tricosenoate and is subjected to $F^+$-ion etching, and the thickness loss curve of another LB film which is made of ω-tricosenoic acid and is subjected to $F^+$-ion etching. As is apparent from Fig. 4, the calcium containing LB film is excellent in resistance to dry etching.

In the above embodiments, the LB film contains aluminum or calcium. Alternatively, the LB film may contain at least one element selected from a group consisting of titanium, chromium and cadmium. Further, the LB film may be made of the metal salt of toricosenoic acid, which is one of organic acids having a tripple bond. In the above embodiments, the LB film is exposed to an X-ray beam or electron beam. Alternatively, the LB film may be exposed to one of a light beam and an ion beam which act as an energy beam.

As has been explained in the foregoing, according to the present invention, an ultra-fine pattern necessary for making a semiconductor device can be formed very accurately by using an LB film, and moreover the LB film is sensitive to radiations. Hence, the lithography used in fabricating a very large scale integration circuit is improved in a great degree.

**Claims**

1. A method of forming a pattern, comprising the steps of:
forming a Langmuir-Blodgett film (4, 4′) on a substrate (1) through a thin film (3; 2′) to be subjected to patterning, the Langmuir-Blodgett film (4, 4′) containing a metal;
exposing the Langmuir-Blodgett film to an energy beam (6, 6′) so that the Langmuir-Blodgett film is selectively irradiated with the energy beam;
dissolving the unirradiated part of the Langmuir-Blodgett film to form a pattern of the Langmuir-Blodgett film; and
selectively etching the thin film (3; 2′) with reactive ions (7, 7′) by using the pattern of the Langmuir-Blodgett film as a mask.

2. A method of forming a pattern as claimed in Claim 1, wherein the thin film to be subjected to patterning is a thin resist film (3).

3. A method of forming a pattern as claimed in Claim 1 or 2, wherein the Langmuir-Blodgett film is made of the metal salt of an alkyl carboxylic acid.

4. A method of forming a pattern as claimed in Claim 1 or 2, wherein the Langmuir-Blodgett film is made of the metal salt of an organic acid having at least one double or tripple bond.

5. A method of forming a pattern as claimed in Claim 1 or 2, wherein the Langmuir-Blodgett film contains at least one element selected from a group consisting of aluminum, titanium, calcium, chromium and cadmium.

6. A method of forming a pattern as claimed in Claim 1, wherein the Langmuir-Blodgett film is selectively irradiated with one of a light beam, an electron beam (6'), an ion beam and an X-ray beam (6), to form a desired pattern of the Langmuir-Blodgett film.

FIG. IA

FIG. IB

FIG. IC

FIG. ID

FIG. IE

## FIG. 2

THICKNESS LOSS QUANTITY (Å)

LB FILMS OF STEARIC ACID

LB FILMS OF Aℓ STEARATE

3000

2000

1000

10   20   30   40   50   60

ETCHING TIME (MINUTE)

## FIG. 4

THICKNESS LOSS QUANTITY (Å)

1500

1000

500

LB FILMS OF ω-TRICOSENOIC ACID

LB FILMS OF Ca ω-TRICOSENOATE

2   4   6   8   10

ETCHING TIME (MINUTE)

FIG. 3A

FIG. 3B

FIG. 3C

FIG. 3D